**Europäisches Patentamt**

**European Patent Office**

**Office européen des brevets**

(19)

(11) Veröffentlichungsnummer: **0 087 581**
**B1**

(12) **EUROPÄISCHE PATENTSCHRIFT**

(45) Veröffentlichungstag der Patentschrift:
**13.05.87**

(51) Int. Cl.⁴: **H 01 L 21/316**

(21) Anmeldenummer: **83100646.5**

(22) Anmeldetag: **25.01.83**

(54) **Verfahren zur Herstellung von Siliziumoxidschichten.**

(30) Priorität: **22.02.82 DE 3206376**

(43) Veröffentlichungstag der Anmeldung:
**07.09.83 Patentblatt 83/36**

(45) Bekanntmachung des Hinweises auf die Patenterteilung:
**13.05.87 Patentblatt 87/20**

(84) Benannte Vertragsstaaten:
**AT CH DE FR GB IT LI SE**

(56) Entgegenhaltungen:
**US - A - 4 139 658**
**US - A - 4 149 905**

**JOURNAL OF THE ELECTROCHEMICAL SOCIETY,**
**Band 127, Nr. 1, Januar 1980, New York, C. HASHIMOTO**
**et al. "A method of forming thin and highly reliable gate**
**oxides", Seiten 129-135**

(73) Patentinhaber: **Siemens Aktiengesellschaft Berlin und**
**München, Wittelsbacherplatz 2, D-8000 München 2 (DE)**

(72) Erfinder: **Grasser, Leo, Dipl.-Phys.,**
**Ottobrunnerstrasse 101, D-8000 München 83 (DE)**

**Beschreibung**

Die Erfindung betrifft ein Verfahren zur Herstellung von Siliziumoxidschichten auf Siliziumoberflächen mit mindestens zwei Oxidationsschritten, bei dem ein erster Schritt bei niedriger Oxidationstemperatur in einer ein Gemisch aus Sauerstoff und Chlorwasserstoff mit geringer Chlorwasserstoffkonzentration enthaltenden Atmosphäre durchgeführt wird und bei dem ein zweiter Schritt bei hoher Oxidationstemperatur durchgeführt wird.

Zur Herstellung hochintegrierter Schaltkreise in MOS-Technologie werden insbesondere für die Gateoxide geringe Oxiddicken mit hoher Qualität benötigt, wobei die auf eine Halbleiteroberfläche aufgebrachten Oxidschichten vor allem eine gleichmässige und reproduzierbare Dicke, eine hohe Durchbruchspannung, eine geringe Defekthäufigkeit, geringe Oberflächenladungen und eine gute Passivierung aufweisen sollen.

Gute Oxidqualitäten können zum einen durch sehr aufwendige Reinigungsprozesse erreicht werden, zum anderen ist es bekannt, die Oxidation von Siliziumoberflächen in einer Gasmischung aus Sauerstoff und Chlorwasserstoff durchzuführen, wobei jedoch geringe Oxidationstemperaturen geringe Defektraten und eine schlechte Passivierung und hohe Oxidationstemperaturen hohe Defektraten und eine gute Passivierung ergeben.

In US-A-4 139 658 ist ein Verfahren zur Herstellung von Siliziumoxidschichten beschrieben, bei dem unter Aufrechterhaltung einer konstanten Oxidationstemperatur zwischen 800 und 1200 °C ein erster Oxidationsschritt in einer Sauerstoff, Wasserstoff und Halogenwasserstoff enthaltenden Atmosphäre und anschliessend ein zweiter Oxidationsschritt in trockener Sauerstoffatmosphäre durchgeführt werden, um eine hohe Strahlungsfestigkeit des Oxids zu erzielen.

Zur Verbesserung der Qualität von dünnen Siliziumoxidschichten ist aus dem Artikel «A Method of Forming Thin and Highly Reliable Gate Oxides» von C. Hashimoto, S. Muramoto, N. Shiono and O. Nakajima, Journal of the Electrochemical Society, Jan. 1980, Seiten 129 bis 135, ein zweistufiges Oxidationsverfahren der eingangs genannten Art bekannt, bei dem im ersten Oxidationsschritt mit einem Sauerstoff/Chlorwasserstoffgemisch mit relativ geringer Chlorwasserstoff-Konzentration und relativ geringer Temperatur und im zweiten Oxidationsschritt mit relativ hoher Temperatur und einer Gasmischung aus Stickstoff, Sauerstoff und Chlorwasserstoff gearbeitet wird. Ein Zusammenmischen dieser drei Gase beim zweiten Oxidationsschritt ist jedoch insbesondere aufgrund des über 90% betragenden Anteils von Stickstoff nachteilig, da sich die Gaskomponenten nicht homogen mischen und so einzelne Komponenten auf der Halbleiterscheibe nicht gleichzeitig verteilt werden. Dies führt insbesondere an der Grenzfläche zwischen Silizium und Siliziumdioxid zu Siliziumnitritschichten, die das Langzeitverhalten der Oxidschichten verschlechtern. Die hohen Oxidationstemperaturen von 900 bis 1100 °C beim ersten Schritt und über 1100 °C beim zweiten Schritt verschlechtern ferner durch unvermeidliche Diffusionsprozesse die Halbleitereigenschaften von bereits vor der Oxidation dotierten Halbleiterscheiben. Geringere Oxidationstemperaturen führen bei der genannten Gasmischung jedoch zu langen Oxidationsdauern.

Aufgabe der Erfindung ist es, hier Abhilfe zu schaffen und ein Verfahren zur Herstellung von dünnen Siliziumoxidschichten verbesserter Qualität vorzusehen.

Diese Aufgabe wird bei einem Verfahren der eingangs genannten Art erfindungsgemäss dadurch gelöst, dass der zweite Schritt in trockener Sauerstoffatmosphäre durchgeführt wird. Dadurch gelingt es, sowohl das momentane als auch das zeitabhängige Durchbruchsverhalten der Oxidschichten zu verbessern.

Eine weitere Verbesserung der Oxidqualität wird dadurch erreicht, dass nach dem ersten Schritt während eines Zwischenschrittes in einer ein Gemisch aus Sauerstoff und Chlorwasserstoff mit geringer Chlorwasserstoffkonzentration enthaltenden Atmosphäre die Oxidationstemperatur von der niedrigen Oxidationstemperatur auf die hohe Oxidationstemperatur gesteigert wird.

Weitere Ausgestaltungen des erfindungsgemässen Verfahrens sind in Unteransprüchen gekennzeichnet.

Die Erfindung wird im folgenden anhand der ein Temperatur-Zeit-Diagramm eines Ausführungsbeispiels des erfindungsgemässen Verfahrens zeigenden Figur näher erläutert.

Im ersten Oxidationsschritt $B_1$ wird das zu oxidierende Siliziummaterial, z.B. Siliziumscheiben, in einem Ofen, z.B. einem Oxidationsrohr, bei niedriger Oxidationstemperatur $T_1$ in einer ein Gemisch aus Sauerstoff und Chlorwasserstoff enthaltenden Atmosphäre oxidiert. Vorteilhafterweise wird das Oxidationsrohr zunächst mit diesem Gasgemisch gespült und nach der Spülung das zu oxidierende Gut einschliesslich Halterungen (Horden) in das Oxidationsrohr gebracht und bei der Temperatur $T_1$ ebenfalls vom durchfliessenden Gasgemisch gespült. Das Gasgemisch besteht aus trockenem Sauerstoff mit geringer Chlorwasserstoffkonzentration, vorzugsweise 2,5 bis 4, insbesondere 3 Volumenprozent Chlorwasserstoff (HCl). Die Temperatur $T_1$ sollte 700 bis 900 °C, vorzugsweise 750 bis 850, insbesondere 800 °C betragen. Nach 15 bis 45, vorzugsweise 25 bis 35 Minuten (Zeitpunkt $t_1$) wird bei guter Oberflächenreinigung der Siliziumoberfläche eine Oxiddicke von weniger als 1 nm erreicht.

Der an den ersten Schritt $B_1$ anschliessende der Aufheizung dienende Zwischenschritt $B_2$, in dem das Oxidationsrohr von der niedrigen Oxidationstemperatur $T_1$ auf die hohe Oxidationstemperatur $T_2$ aufgeheizt wird, wird vorteilhafterweise in einer der im ersten Schritt $B_1$ verwendeten Atmosphäre entsprechenden Atmosphäre durchgeführt. Durch einen HCl-Gehalt der Atmosphäre wird damit eine Verunreinigung der Oxidschichten, insbesondere durch im Oxidationsrohr vorhandene Verunreinigungen, während der Aufheizzeit vermieden. Die Dauer des Zwischenschrittes $B_2$ (Zeitpunkt $t_2$–Zeitpunkt $t_1$) beträgt vorteilhafterweise 15 bis 30 Minuten, die erreichte Oxiddicke beträgt etwa 1 nm. Der Zwischenschritt $B_2$ kann aber auch ohne HCl-Beimischung durchgeführt werden.

In an den Zwischenschritt $B_2$ anschliessenden zweiten Schritt $B_3$ wird bei hoher Oxidationstemperatur $T_2$ in einer Atmosphäre aus reinem, trockenen Sauerstoff oxidiert, wobei die Dauer des zweiten Schrittes $B_3$ (Zeitpunkt $t_3$ minus Zeitpunkt $t_2$) von der gewünschten Gesamtoxiddicke abhängt. Für Gateoxiddicken von $45 \pm 3$ nm, wie sie z.B. bei der Herstellung von 64-k-RAM's benötigt werden, beträgt die Dauer des zweiten Schrittes $B_3$ z.B. 25 Minuten. Die Höhe der hohen Oxidationstemperatur $T_2$ wird etwa im Bereich zwischen 850 bis 1050 °C, vorzugsweise zwischen 900 und 1000 °C gewählt. Zur Erzeugung von geringen Oxiddicken im Bereich zwischen 5 und 10 nm sind Temperaturen $T_2$ im unteren Teil der genannten Bereiche von Vorteil, da bei geringen Oxidationstemperaturen aufgrund der längeren Oxidationszeit aus fertigungstechnischen Gründen gewünschte Oxiddicken genauer herzustellen sind.

Zum Zeitpunkt $t_2$ ist aufgrund des ersten Schrittes $B_1$ bereits eine sehr saubere Zwischenfläche (Interface) hergestellt, durch die mit dem zweiten Schritt $B_3$ erfolgte Passivierung befinden sich nur wenige bewegliche Ladungsträger im Oxid.

Nach dem Erreichen der gewünschten Oxiddicke (Zeitpunkt $t_3$) wird der Ofen im folgenden Abkühlschritt $B_4$ langsam auf mindestens 850 °C (Temperatur $T_3$) abgekühlt und das oxidierte Gut anschliessend (Zeitpunkt $t_4$) entnommen. Die Abkühlungsphase (Zeitpunkt $t_4$ minus Zeitpunkt $t_3$) wird bei Verwendung einer Stickstoffatmosphäre während der Abkühlphase vorzugsweise in ein bis zwei Stunden durchgeführt.

Es hat sich gezeigt, dass zur Vermeidung von durch die Stickstoffatmosphäre eventuell verursachten Stickstoffverbindungen eine Abkühlung in Edelgas-, z.B. Argonatmosphäre, zur Erzielung hoher Oxidqualitäten besonders vorteilhaft ist. Bei Verwendung einer Edelgasatmosphäre ist die Abkühlphase unkritischer. Vorteilhafterweise wird das oxidierte Gut bis auf 700 bis 800 °C abgekühlt.

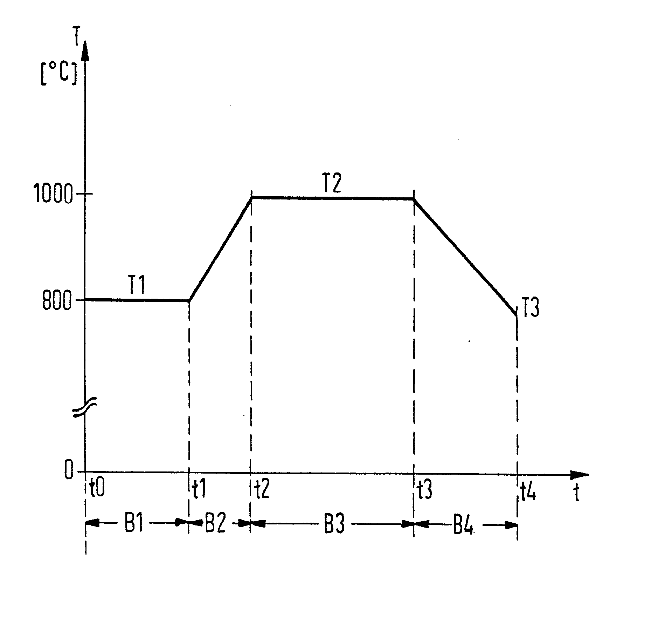

In einem Ausführungsbeispiel wurden als Ausgangsmaterial homogene p-leitende Silizium-Scheiben mit einem Durchmesser von ca. 100 mm verwendet, deren spezifischer Widerstand in etwa 10 $\Omega$ cm betrug. Die Oxidationen wurden in einem rechnergesteuerten Quarzoxidationsrohr mit der Figur entsprechendem konstanten Temperatur-Zeit-Programm durchgeführt und Oxiddicken von 50 nm erzielt. Dabei betrugen die Temperaturen $T_1$ 800 °C, $T_2$ 1000 °C, $T_3$ 800 °C. Die Chlorwasserstoffkonzentration während des ersten Schrittes $B_1$ und des Zwischenschrittes $B_2$ betrug 3 Volumenprozent, der Abkühlschritt $B_4$ wurde in Stickstoffatmosphäre durchgeführt. Die Dauer des ersten Schrittes $B_1$ betrug 30 Minuten, die des Zwischenschrittes $B_2$ 20 Minuten, die des zweiten Schrittes $B_3$ 25 Minuten und die des Abkühlschrittes $B_4$ 100 Minuten.

Um zur Qualitätsprüfung die Durchbruchspannungen der Oxidschichten messen zu können, wurde auf das Siliziumdioxid ganzflächig Aluminium-Silizium mit einer Dicke von ca 1 µm aufgesputtert. Die Metallschicht wurde anschliessend auf fotolithografischem Weg in Rechtecke mit einer Fläche von 25 mm² unterteilt und sodann das Rückseitenoxid der Scheiben entfernt. Als Schlussprozess folgte eine Wasserstoff-Temperung bei 450 °C 30 Minuten lang.

Für den momentanen Oxiddurchbruch, der an etwa 1500 MOS-Kondensatoren gemessen wurde, ergab sich nach der Zusammenfassung und statistischen Auswertung der Messungen ein 50-%-Wert für die Durchbruchspannung von 50 V bei einer Standardabweichung $+ 1 \sigma$ von 1 V und $- 1 \sigma$ von 6 V. Beim nach dem Stand der Technik hergestellten MOS-Kondensatoren ergaben sich dagegen entsprechende Werte von 40 V (50-%-Wert), 3 V ($+ 1 \sigma$) und 7 V ($- 1 \sigma$).

Der zeitabhängige Oxiddurchbruch wurde ebenfalls an etwa 1500 Kondensatoren gemessen. Alle Kondensatoren wurden mit einer Feldstärke von 6 MV/cm belastet. Der gemessene Ausfall durch Oxiddurchbrüche zwischen Beginn und Ende der Belastung ($10^{-6}$ sec bis 1000 Std.) betrug reproduzierbar 12%, während der zeitliche Ausfall innerhalb der angegebenen Zeit bei nach dem Stand der Technik hergestellten Kondensatoren ca. 42% betrug.

**Patentansprüche**

1. Verfahren zur Herstellung von Siliziumoxidschichten auf Siliziumoberfächen mit mindestens zwei Oxidationsschritten, bei dem ein erster Schritt ($B_1$) bei niedriger Oxidationstemperatur ($T_1$) in einer ein Gemisch aus Sauerstoff und Chlorwasserstoff mit geringer Chlorwasserstoffkonzentration enthaltenden Atmosphäre durchgeführt wird und bei dem ein zweiter Schritt ($B_3$) bei hoher Oxidationstemperatur ($T_2$) durchgeführt wird, dadurch gekennzeichnet, dass der zweite Schritt ($B_3$) in trockener Sauerstoffatmosphäre durchgeführt wird.

2. Verfahren nach Anspruch 1, dadurch gekennzeichnet, dass nach dem ersten Schritt ($B_1$) während eines Zwischenschrittes ($B_2$) in einer ein Gemisch aus Sauerstoff und Chlorwasserstoff mit geringer Chlorwasserstoffkonzentration enthaltenden Atmosphäre die Oxidationstemperatur von der niedrigen Oxidationstemperatur ($T_1$) auf die hohe Oxidationstemperatur ($T_2$) gesteigert wird.

3. Verfahren nach Anspruch 1 oder 2, dadurch gekennzeichnet, dass nach dem zweiten Schritt ($B_3$) ein Abkühlungsschritt ($B_4$) in Stickstoffatmosphäre durchgeführt wird.

4. Verfahren nach Anspruch 1 oder 2, dadurch gekennzeichnet, dass nach dem zweiten Schritt ($B_3$) ein Abkühlungsschritt ($B_4$) in Edelgasatmosphäre durchgeführt wird.

5. Verfahren nach einem der Ansprüche 1 bis 4, dadurch gekennzeichnet, dass im ersten Schritt ($B_1$) die Chlorwasserstoffkonzentration 2,5 bis 4 Volumenprozent beträgt.

6. Verfahren nach einem der Ansprüche 1 bis 5, dadurch gekennzeichnet, dass der erste Schritt (B₁) bei einer Oxidationstemperatur (T₁) von etwa 700 bis 900 °C durchgeführt wird.

7. Verfahren nach einem der Ansprüche 1 bis 6, dadurch gekennzeichnet, dass der erste Schritt (B₁) bei einer Oxidationstemperatur (T₁) von etwa 750 bis 850 °C durchgeführt wird.

8. Verfahren nach einem der Ansprüche 1 bis 7, dadurch gekennzeichnet, dass der zweite Schritt (B₃) bei einer Oxidationstemperatur (T₂) von etwa 850 bis 1050 °C durchgeführt wird.

9. Verfahren nach einem der Ansprüche 1 bis 8, dadurch gekennzeichnet, dass der zweite Schritt (B₃) bei einer Oxidationstemperatur (T₂) von etwa 900 bis 1000 °C durchgeführt wird.

## Claims

1. A process for the production of silicon oxide layers on silicon surfaces, comprising at least two oxidation steps, in which a first step (B₁) is carried out at a low oxidation temperature (T₁) in an atmosphere which contains a mixture of oxygen and hydrogen chloride with a small hydrogen chloride concentration, and in which a second step (B₃) is carried out at a high oxidation temperature (T₂), characterised in that the second step (B₃) is carried out in a dry oxygen atmosphere.

2. A process as claimed in Claim 1, characterised in that after the first step (B₁), during an intermediate step (B₂) in an atmosphere which contains a mixture of oxygen and hydrogen chloride with a small hydrogen chloride concentration, the oxidation temperature is increased from the low oxidation temperature (T₁) to the high oxidation temperature (T₂).

3. A process as claimed in Claim 1 or 2, characterised in that after the second step (B₃), a cooling step (B₄) is carried out in a nitrogen atmosphere.

4. A process as claimed in Claim 1 or Claim 2, characterised in that, after the second step (B₃), a cooling step (B₄) is carried out in an inert gas atmosphere.

5. A process as claimed in one of Claims 1 to 4, characterised in that in the first step (B₁), the hydrogen chloride concentration is from 2.5 to 4 volume percent.

6. A process as claimed in one of Claims 1 to 5, characterised in that the first step (B₁) is carried out at an oxidation temperature (T₁) of about 700 to 900 °C.

7. A process as claimed in one of Claims 1 to 6, characterised in that the first step (B₁) is carried out at an oxidation temperature (T₁) of about 750 to 850 °C.

8. A process as claimed in one of Claims 1 to 7, characterised in that the second step (B₃) is carried out at an oxidation temperature (T₂) of about 850 to 1050°C.

9. A process as claimed in one of Claims 1 to 8, characterised in that the second step (B₃) is carried out at an oxidation temperature (T₂) of about 900 to 1000 °C.

## Revendications

1. Procédé de fabrication de couches d'oxyde de silicium sur des surfaces de silicium, comprenant au moins deux stades d'oxydation, dans lequel un premier stade (B₁) est effectué à une température basse d'oxydation (T₁) dans une atmosphère contenant un mélange d'oxygène et de gaz chlorhydrique avec une faible concentration de gaz chlorhydrique et dans lequel un deuxième stade (B₃) est effectué à une température élevée d'oxydation (T₂), caractérisé en ce qu'il consiste à effectuer le deuxième stade (B₃) dans une atmosphère sèche d'oxygène.

2. Procédé suivant la revendication 1, caractérisé en ce qu'il consiste, après le premier stade (B₁), à porter pendant un stade intermédiaire (B₂), dans une atmosphère contenant un mélange d'oxygène et de gaz chlorhydrique avec une faible concentration de gaz chlorhydrique, la température d'oxydation de la température basse d'oxydation (T₁) à la température élevée d'oxydation (T₂).

3. Procédé suivant la revendication 1 ou 2, caractérisé en ce qu'il consiste à effectuer, après le deuxième stade (B₃), un stade de refroidissement (B₄) dans une atmosphère d'azote.

4. Procédé suivant la revendication 1 ou 2, caractérisé en ce qu'il consiste à effectuer, après le deuxième stade (B₃), un stade de refroidissement (B₄) dans une atmosphère de gaz rare.

5. Procédé suivant l'une des revendications 1 à 4, caractérisé en ce qu'au premier stade (B₁), la concentration de gaz chlorhydrique représente de 2,5 à 4% en volume.

6. Procédé suivant l'une des revendications 1 à 5, caractérisé en ce qu'il consiste à effectuer le premier stade (B₁) à une température d'oxydation (T₁) de 700 à 900 °C environ.

7. Procédé suivant l'une des revendications 1 à 6, caractérisé en ce qu'il consiste à effectuer le premier stade (B₁) à une température d'oxydation (T₁) de 750 à 850 °C environ.

8. Procédé suivant l'une des revendications 1 à 7, caractérisé en ce qu'il consiste à effectuer le deuxième stade (B₃) à une température d'oxydation (T₂) de 850 à 1050 °C environ.

9. Procédé suivant l'une des revendications 1 à 8, caractérisé en ce qu'il consiste à effectuer le deuxième stade (B₃) à une température d'oxydation (T₂) de 900 à 1000 °C environ.